# EUROPEAN PATENT APPLICATION

(11) **EP 4 498 158 A1**
(43) Date of publication of application: **29.01.2025**
(21) Application number: 23774638.3
(22) Date of filing: 13.03.2023
(51) Int. Cl.: G03F 7/004, C08K 3/013, C08K 3/36, C08L 79/08, G03F 7/038, H05K 1/03

(54) **PHOTOSENSITIVE RESIN COMPOSITION, PHOTOSENSITIVE RESIN COMPOSITION FILM, CURED PRODUCT, AND ELECTRONIC COMPONENT USING SAME**

(30) Priority: 22.03.2022 JP 2022044940
(71) Applicant: Toray Industries, Inc., Tokyo 103-8666 (JP)
(72) Inventor: KATSURADA, Yuki, Otsu-shi, Shiga 520-8558 (JP); TAKIGUCHI, Ayumi, Otsu-shi, Shiga 520-8558 (JP); KANAMORI, Daisuke, Otsu-shi, Shiga 520-8558 (JP)
(74) Representative: Kador & Partner Part mbB
(86) International application number: PCT/JP2023/009571
(87) International publication number: WO 2023/182041

(57) **Abstract**

Provided is a photosensitive resin composition having excellent patterning property and providing excellent pressure resistance (elastic modulus) of a cured product. This photosensitive resin composition contains (A) a polyimide, (B) a cationic polymerizable compound, (C) a photocationic polymerization initiator, and (D) crystalline silica and has negative photosensitivity.

## Description

### TECHNICAL FIELD

The present invention relates to a photosensitive resin composition, a photosensitive resin composition film, a cured product, and electronic components prepared therefrom. More specifically, it relates to a photosensitive resin composition that can be suitably used as roofing material for hollow structures of high-frequency filters such as surface acoustic wave (SAW) filters and bulk acoustic wave (BAW) filters.

### BACKGROUND ART

Because fine processing is feasible by means of the photolithography technique, photosensitive resin compositions are in wide use for insulating films of circuit boards. Furthermore, photosensitive resin compositions can be molded to provide film shaped materials. Being in the form of films, they are now in wider use as roofing material to form hollow structures of electronic components. In recent years, photosensitive resin composition films used to form roofs of hollow structures are required to have high pattern processibility in steps for creating fine through-holes and high pressure resistance in steps for sealing.

To improve pressure resistance, techniques that adopt the addition of an inorganic filler to increase the elastic modulus have been proposed, and in particular, the technique proposed in Patent document 1, which adds a glass filler that has a suitable refractive index to work with photosensitive resin compositions, is expected not only to ensure improved pressure resistance due to the addition of a filler but also to ensure high pattern processibility due to suppression of the scattering of light used for light exposure.

In addition, some methods have been proposed that are designed to achieve an increased resolution by using a chemical amplification type photocationic polymerizable material to create a pattern, and in particular, the technique proposed in Patent document 2, which uses a photosensitive resin composition including at least one compound selected from the group consisting of polyamide, polyimide, polyamide-imide, and polybenzoxazole, is expected to achieve both high pattern processibility and high pressure resistance simultaneously.

### PRIOR ART DOCUMENTS

### PATENT DOCUMENTS

Patent document 1: Japanese Unexamined Patent Publication (Kokai) No. 2015-118194
Patent document 2: International Publication WO 2021/059843

### SUMMARY OF INVENTION

### PROBLEMS TO BE SOLVED BY THE INVENTION

However, the photosensitive resin composition described in Patent document 1 fails to achieve a sufficient resolution and has difficulty in forming a fine pattern, leading to difficulty in having a sufficient pattern processibility. Also, the photosensitive resin composition described in Patent document 2 can only provide a cured product having a low elastic modulus and therefore, it has difficulty in achieving a sufficient pressure resistance.

In view of such circumstances, the inventors of the present invention conducted extensive studies and consequently found that negative type photocationic polymerizable photosensitive resin compositions that include polyimide and crystalline silica can show high pattern processibility and form cured products having high pressure resistance (elastic modulus).

### MEANS OF SOLVING THE PROBLEMS

The present invention, which is designed for solving the above problems, is as described below.

A photosensitive resin composition characterized by including a polyimide (A), a cationic polymerizable compound (B), a photocationic polymerization initiator (C), and a crystalline silica (D), and
having negative type photosensitivity.

### ADVANTAGEOUS EFFECTS OF THE INVENTION

The photosensitive resin composition according to the present invention is designed to provide a negative type photosensitive resin composition having high pattern processibility and serving to form a cured product with high pressure resistance (elastic modulus) and also provide a photosensitive resin composition film, cured product, and electronic components prepared therefrom.

### DESCRIPTION OF PREFERRED EMBODIMENTS

The photosensitive resin composition according to the present invention is a photosensitive resin composition characterized by including a polyimide (A), a cationic polymerizable compound (B), a photocationic polymerization initiator (C), and a crystalline silica (D) and having negative type photosensitivity.

The photosensitive resin composition according to the present invention is preferably a negative type one. When producing the roof of a hollow structure as described later, the light-exposed portion that is designed to form the roof hardens under light to form a strong roof and accordingly this prevents breakage of the roof during the production process. In addition, being of negative type, the photosensitive resin composition before being supplied to the photo-curing step can be maintained at a low viscosity compared to positive type ones, and this ensures high laminatability during the roof formation process.

### Polyimide (A)

The photosensitive resin composition according to the present invention contains a polyimide (A), and this ensures good film-forming properties during the film forming process and serves to produce a cured product with high elastic modulus.

There are no specific limitations on the weight average molecular weight of the polyimide (A), but its weight average molecular weight is preferably 1,000 or more and 200,000 or less. If it has a weight average molecular weight of 1,000 or more, it will have high film forming properties. If it has a weight average molecular weight of 200,000 or less, it will show high developability during pattern processing. Here, for the present invention, the weight average molecular weight of the polyimide (A) is measured by gel permeation chromatography (GPC) and converted in terms of polystyrene. The polyimide (A) may be either a single component material or a mixture of two or more polyimide components.

It is preferable for the polyimide (A) to have a structure derived from a carboxylic acid residue at a molecular chain end. The presence of a structure derived from a carboxylic acid residue at a molecular chain end of the polyimide (A) is preferable because the molecular chain end is devoid of an amine-terminated structure acting as a functional group that can inhibit cationic polymerization, and as a result, it serves to develop a sufficiently high cationic polymerizability even when using polyimide.

Here, the aforementioned structure derived from a carboxylic acid residue present at a molecular chain end of the polyimide (A) is an organic group derived from a carboxylic acid residue that can work to form polyimide, and specifically, it is derived from a tetracarboxylic acid or an anhydride, dianhydride, etc., thereof. Of those described above, it is preferable to adopt one in which the structure derived from a carboxylic acid residue present at a molecular chain end of the polyimide (A) is a structure derived from a tetracarboxylic dianhydride. The presence of a structure derived from a tetracarboxylic acid dianhydride at a molecular chain end is preferable because it ensures improved storage stability of the photosensitive resin composition before heat curing. On the other hand, it is also preferable because when forming a cured product, the carboxylic anhydride group at a molecular end forms a reactive functional group, leading to enhanced heat resistance and chemical resistance after heat curing.

In addition, it is preferable for the polyimide (A) to have an alicyclic structure in the main chain. The presence of an alicyclic structure in the main chain of the polyimide (A) serves to increase the light transmittance of the photosensitive resin composition at the wavelength of light used for light exposure, making it easier to perform processing at a large film thickness of 20 µm or more. Furthermore, the reactivity for cationic polymerization increases and a cured product with improved chemical resistance can be obtained, although the reason therefor is not clearly known. In addition, the presence of an alicyclic structure serves to allow the refractive index of the polyimide to be relatively low. It can become close to the refractive index of the crystalline silica (D) which will be described later. This allows transparency to be maintained even when the crystalline silica (D) is added as a filler, making it possible to perform fine pattern processing.

The photosensitive resin composition according to the present invention preferably includes the polyimide (A) that has a structure derived from a carboxylic acid residue at a molecular chain end, but it is also possible to include a polymer compound that is devoid of a structure derived from a carboxylic acid residue at a molecular chain end. Here, it should be noted that in the case where the photosensitive resin composition according to the present invention contains a polyimide (A) that is devoid of a structure derived from a carboxylic acid residue at a molecular chain end, its content should preferably be as low as possible, and specifically, the polyimide (A) that is devoid of a structure derived from a carboxylic acid residue at a molecular chain end preferably accounts for 0 part by mass or more and 50 parts by mass or less, more preferably 0 part by mass or more and 30 parts by mass or less, still more preferably 0 part by mass or more and 10 parts by mass or less, and particularly preferably 0 part by mass or more and 2 parts by mass or less, relative to the total amount, which accounts for 100 parts by mass, of the polyimide (A) that has a structure derived from a carboxylic acid residue at a molecular chain end.

In addition, it is preferable for the polyimide (A) to be soluble in alkali. If it is soluble in alkali, it is preferable because development with an alkaline aqueous solution can be performed when it is developed for pattern processing, and it is not necessary to use an organic solvent that can have an environmental impact. Here, being soluble in alkali means that 0.1 g or more of the material can be dissolved at 25°C in 100 g of a 2.38 mass% aqueous solution of tetramethylammonium hydroxide.

In order to be soluble in alkali, the polyimide (A) preferably has an alkali soluble functional group. An alkali soluble functional group is an acidic functional group and specific examples thereof include phenolic hydroxyl groups, carboxyl groups, and sulfonic acid groups. Among the various alkali soluble groups given above, it is preferable that a phenolic hydroxyl group be used as alkali soluble group from the perspective of storage stability of the photosensitive resin composition, corrosion prevention of the copper wiring, which is a conductive material, etc. Thus, it is preferable for the polyimide (A) to be a compound that has a phenolic hydroxyl group in the molecular chain. Furthermore, the presence of a phenolic hydroxyl group in the molecule of the polyimide (A) serves to improve the dispersibility of the crystalline silica (D), which will be described later.

Examples of the structure (organic group) derived from a carboxylic acid residue present at a molecular chain end of the polyimide (A) include, but not limited to, aromatic acid dianhydrides, alicyclic acid dianhydrides, and aliphatic acid dianhydrides. Here, these may be used singly or as a combination of two or more thereof.

For the present invention, the polyimide (A) is preferably a chemical compound having a structure as represented by the general formula (1).

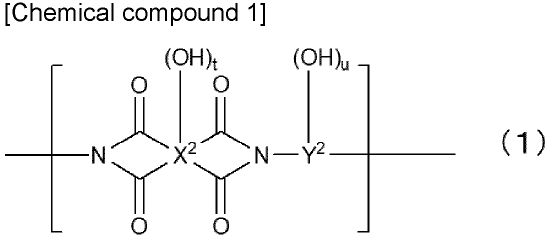

(In the general formula (1), X² is a divalent to decavalent organic group, and Y² is a divalent to tetravalent organic group. Furthermore, t and u are each independently an integer of 0 to 4.)

In the general formula (1), Y² is a divalent to tetravalent organic group and represents an organic group derived from diamine.

In the general formula (1) that represents the polyimide (A), Y² preferably contains a diamine residue having a phenolic hydroxyl group. The inclusion of a diamine residue having a phenolic hydroxyl group allows the resin to have an appropriate solubility in the alkaline developer, and this ensures a high contrast between the light-exposed and unexposed regions to achieve the formation of a desired pattern.

Specific examples of diamines having phenolic hydroxyl groups include, but not limited to, aromatic diamines such as bis(3-amino-4-hydroxyphenyl)hexafluoropropane, bis(3-amino-4-hydroxyphenyl)sulfone, bis(3-amino-4-hydroxyphenyl)propane, bis(3-amino-4-hydroxyphenyl)methylene, bis(3-amino-4-hydroxyphenyl)ether, bis(3-amino-4-hydroxy)biphenyl, 2,2'-ditrifluoromethyl-5,5'-dihydroxy-4,4'-diaminobiphenyl, bis(3-amino-4-hydroxyphenyl)fluorene, and 2,2'-bis(trifluoromethyl)-5,5'-dihydroxybenzidine; compounds derived therefrom by substituting part of the hydrogen atoms in the aromatic rings and/or hydrocarbons with alkyl groups having 1 to 10 carbon atoms, fluoroalkyl groups, halogen atoms, or the like; and diamines having structures as shown below. Other diamines adopted for copolymerization may be used in their original forms or as the corresponding diisocyanate compounds or trimethylsilylated diamines. It may also be effective to use two or more of these diamine components in combination.

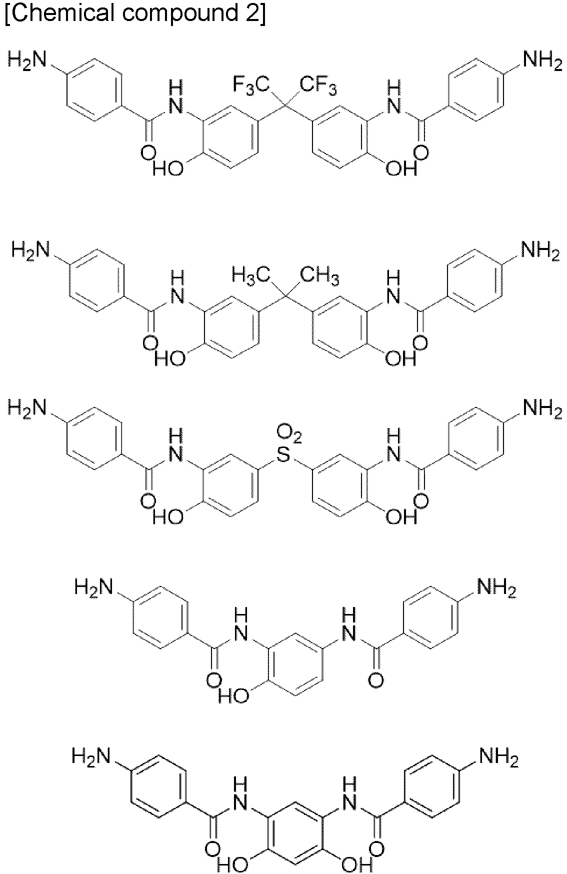

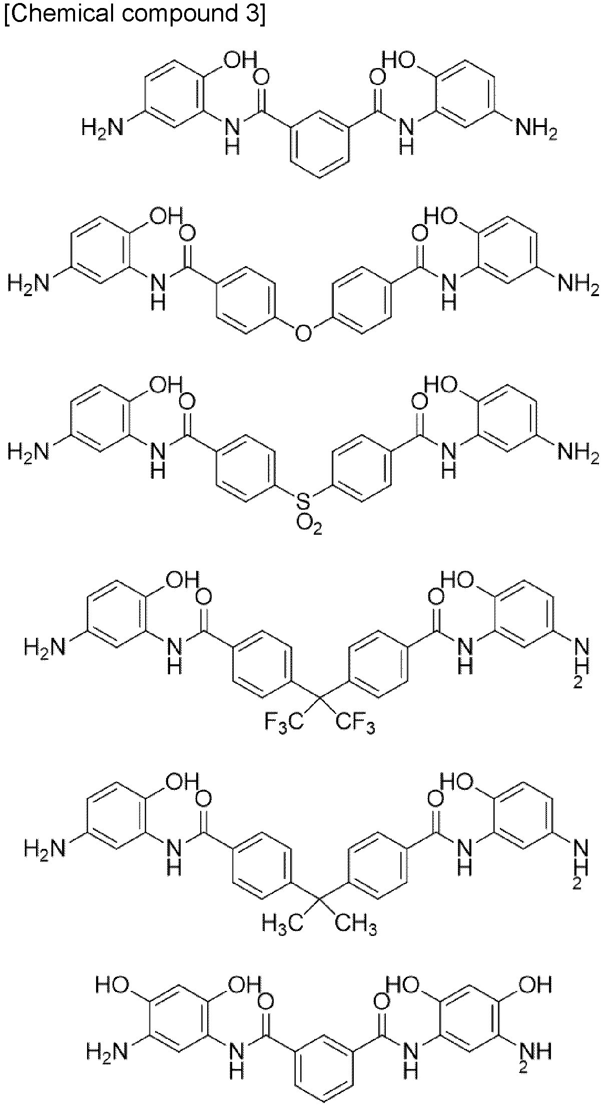

In the general formula (1), Y² may also include a diamine residue having an aromatic group other than those mentioned above. If these are copolymerized, it serves to increase the heat resistance. Specific examples of diamine residues having aromatic rings include, but not limited to, aromatic diamines such as 3,4'-diaminodiphenyl ether, 4,4'-diaminodiphenyl ether, 3,4'-diaminodiphenyl methane, 4,4'-diaminodiphenyl methane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy)benzene, benzine, m-phenylene diamine, p-phenylene diamine, 1,5-naphthalene diamine, 2,6-naphthalene diamine, bis(4-aminophenoxyphenyl) sulfone, bis(3-aminophenoxyphenyl) sulfone, bis(4-aminophenoxy) biphenyl, bis{4-(4-aminophenoxy)phenyl} ether, 1,4-bis(4-aminophenoxy) benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl, as well as compounds derived therefrom by substituting part of the hydrogen atoms in the aromatic rings and/or hydrocarbons with alkyl groups having 1 to 10 carbon atoms, fluoroalkyl groups, halogen atoms, or the like. Other diamines adopted for copolymerization may be used in their original forms or in the form of corresponding diisocyanate compounds or trimethylsilylated diamines. It may also be effective to use two or more of these diamine components in combination.

Furthermore, in the general formula (1) given above, X² represents a carboxylic acid residue and it is a divalent to decavalent organic group.

The carboxylic acid residue preferably has a structure derived from an alicyclic tetracarboxylic acid dianhydride. This means that it is preferable for the polyimide (A) to have a structure derived from an alicyclic tetracarboxylic acid dianhydride. If the carboxylic acid residue, i.e., the polyimide (A), has a structure derived from an alicyclic tetracarboxylic acid dianhydride, it serves to increase the light transmittance of the photosensitive resin composition at the wavelength of light used for exposure, making it easier to perform processing at a large film thickness of 20 µm or more. It is preferable for the polyimide (A) to have a structure derived from an alicyclic tetracarboxylic acid dianhydride because it ensures an increase in the reactivity for cationic polymerization, leading to a cured product with higher chemical resistance, as compared with the use of an aromatic acid dianhydride, although the reason is not clearly known. In addition, the presence of an alicyclic structure serves to allow the refractive index of the polyimide to be relatively low. It can be close to the refractive index of the crystalline silica (D), which will be described later. This allows transparency to be maintained even when the crystalline silica (D) is added as a filler, making it possible to perform fine pattern processing.

In addition, of the various alicyclic tetracarboxylic acid dianhydrides, it is preferable to adopt an alicyclic tetracarboxylic acid dianhydride having a polycyclic structure because it serves to provide a cured product with higher chemical resistance and higher ion migration resistance.

Furthermore, the polyimide (A) used for the present invention preferably has a structure derived from a compound that is represented by at least either of the general formulas (2) and (3).

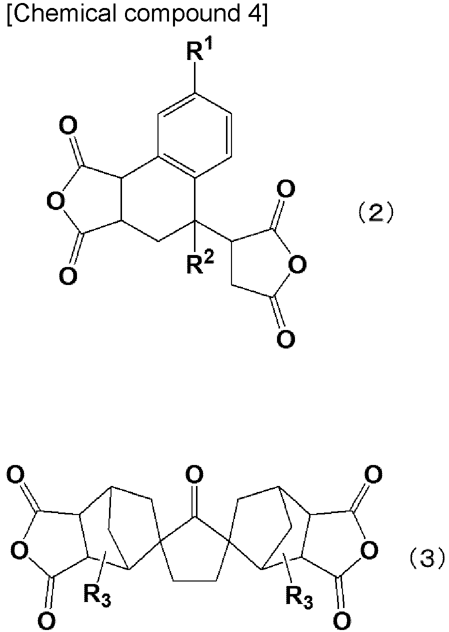

(In the formula, R¹, R², and R³ are each independently a hydrogen atom or a methyl group.) If the polyimide (A) has a structure derived from a compound that is represented by the general formula (2) or (3), it is preferable because the resin backbone is so flexible that the photosensitive resin composition prior to heat curing is high in solubility in organic solvents and precipitation of resin does not occur significantly in the composition, leading to higher storage stability.

Specific examples of organic groups derived from alicyclic tetracarboxylic dianhydrides having polycyclic structures include 4-(2,5-dioxotetrahydrofuran-3-yl)-1,2,3,4-tetrahydronaphthalene-1,2-dicarboxylic dianhydride, 4-(2,5-dioxotetrahydrofuran-3-yl)-4-methyl-1,2,3,4-tetrahydronaphthalene-1,2-dicarboxylic dianhydride, 4-(2,5-dioxotetrahydrofuran-3-yl)-7-methyl-1,2,3,4-tetrahydronaphthalene-1,2-dicarboxylic dianhydride, norbornane-2-spiro-2'-cyclopentanone-5'-spiro-2"-norbornane-5,5",6,6"-tetracarboxylic dianhydride, and norbornane-2-spiro-2'-cyclohexanone-6'-spiro-2"-norbornane-5,5",6,6"-tetracarboxylic dianhydride.

In addition, the carboxylic acid residues may further include an acid anhydride other than the alicyclic tetracarboxylic dianhydrides having polycyclic structures mentioned above. Specific examples thereof include, but not limited to, aromatic tetracarboxylic dianhydrides such as pyromellitic dianhydride, 3,3',4,4'-biphenyl tetracarboxylic dianhydride, 2,3,3',4'-biphenyl tetracarboxylic dianhydride, 2,2',3,3'-biphenyl tetracarboxylic dianhydride, 3,3',4,4'-benzophenone tetracarboxylic dianhydride, 2,2',3,3'-benzophenone tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalene tetracarboxylic dianhydride, 9,9-bis(3,4-dicarboxyphenyl)fluorene dianhydride, 9,9-bis{4-(3,4-dicarboxyphenoxy)phenyl}fluorene dianhydride, 2,3,6,7-naphthalene tetracarboxylic dianhydride, 2,3,5,6-pyridine tetracarboxylic dianhydride, 3,4,9,10-perylene tetracarboxylic dianhydride, and 2,2-bis(3,4-dicarboxyphenyl)hexafluoropropane dianhydride, and others such as 3,3',4,4'-diphenylsulfone tetracarboxylic dianhydride, 1,2,3,4-cyclobutane tetracarboxylic dianhydride, 1,2,3,4-cyclopentane tetracarboxylic dianhydride, 1,2,4,5-cyclohexane tetracarboxylic dianhydride, 5-(2,5-dioxotetrahydrofuryl)-3-methyl-3-cyclohexene-1,2-dicarboxylic dianhydride, 2,3,5-tricarboxy-2-cyclopentaneacetic dianhydride, and 2,3,4,5-tetrahydrofuran tetracarboxylic dianhydride. Here, these may be used singly or as a combination of two or more thereof.

The molar ratio of the structure represented by the general formula (1) can be determined by an appropriate method such as calculation from the molar ratio of the monomers used in the polymerization or detection of peaks attributable to polyamide structures, imide precursor structures, and/or imide structures in the resulting resin, photosensitive resin composition, or cured product analyzed by means of a nuclear magnetic resonance (NMR) apparatus.

A polyimide (A) having a structure derived from a carboxylic acid residue at a molecular chain end can be produced by feeding the acid anhydride in a larger amount relative to the diamine used in the polymerization process. In this process, the total amount of amine residues preferably accounts for 60 mol% or more and 98 mol% or less of the total amount of carboxylic acid residues, which accounts for 100 mol%, in the polyimide (A). This means that the polyimide (A) is preferably a compound produced through a polymerization process in which amine residues account for 60 to 98 mol% relative to the total amount of carboxylic acid residues, which accounts for 100 mol%. When the total amount of amine residues accounts for 60 mol% or more, the weight average molecular weight is likely to be 1,000 or more to ensure good film forming properties in the film production process, wherein when it accounts for 98 mol% or less, the proportion of polymer compounds having amine residues at molecular chain ends is likely to be so small that the progress of the cationic polymerization reaction is facilitated to ensure the formation of a cured product having a higher chemical resistance.

Another good method to produce a polyimide (A) having a structure derived from a carboxylic acid residue at a molecular chain end is to use a specific compound, specifically an acid anhydride, selected from among those compounds commonly used as an end capping agent.

Furthermore, if an acid anhydride having a phenolic hydroxyl group, carboxyl group, sulfonic acid group, thiol group, vinyl group, ethynyl group, or allyl group is used as an end capping agent to cap the molecular chain ends of the polyimide (A), this serves to allow the dissolution rate of the polyimide (A) in an alkaline aqueous solution and the mechanical characteristics of the intended cured product to be easily controlled in desirable ranges. In addition, a plurality of different end capping agents may be reacted to introduce a plurality of different chain end groups.

Examples of preferable acid anhydrides to use as end capping agents include phthalic anhydride, maleic anhydride, nadic anhydride, cyclohexane dicarboxylic anhydride, and 3-hydroxyphthalic anhydride. Two or more of these may be used in combination.

A polyimide (A) containing any of these end capping agents becomes a polyimide (A) having a structure derived from a carboxylic acid residue at a molecular chain end. Here, an end capping agent that can be used to produce a polyimide (A) having a structure derived from a carboxylic acid residue at a molecular chain end can be easily detected by such methods as described below. For example, a polyimide (A) containing an end capping agent is dissolved in an acidic solution to decompose it into its constituent amine and acid anhydride components and analyzing these components by means of gas chromatography (GC), NMR spectroscopy, etc. This serves for easy detection of the end capping agent used for the present invention. In another method, detection can be carried out easily by subjecting the resin component containing an end capping agent directly to pyrolysis gas chromatograph (PGC), infrared spectroscopy, or 13C-NMR spectroscopy.

For the present invention, a polyimide (A) can be synthesized by, for example, the method described below, although the invention is not limited thereto. A polyimide structure can be synthesized through a generally known process designed to replace part of the diamine with a primary monoamine used as end capping agent or replace the tetracarboxylic dianhydride with a dicarboxylic anhydride used as end capping agent. For example, a polyimide precursor is prepared through a process in which a tetracarboxylic dianhydride, a diamine compound, and a monoamine are reacted at a low temperature, a process in which a tetracarboxylic dianhydride, a dicarboxylic anhydride, and a diamine compound at a low temperature, or a process in which a tetracarboxylic dianhydride and an alcohol are reacted to form a diester, which is then reacted in the presence of a diamine, a monoamine, and a condensation agent. Subsequently, a polyimide is synthesized by a generally known imidization reaction method.

After being polymerized by such a method as described above, the resulting polyimide (A) is preferably precipitated by adding a large amount of water or a liquid mixture of methanol and water and then filtered, dried, and isolated. The drying temperature is preferably 40°C to 100°C, more preferably 50°C to 80°C. This step serves to remove unreacted monomers and oligomers such as dimmers and trimers to allow a film with improved characteristics to be obtained after heat curing.

It is preferable for the polyimide (A) in use for the present invention to have an imidization rate of 50% or more, more preferably 80% or more, still more preferably 90% or more, and most preferably 95% or more. If the polyimide (A) has an imidization rate of 50% or more, it serves to suppress changes in the ring closure rate during heat curing, thereby leading to a reduced stress. For the present invention, the imidization rate can be easily determined by, for example, the method described below. First, an infrared absorption spectrum of the polymer is measured to confirm the presence of absorption peaks of the imide structure attributed to polyimide (near 1,780 cm⁻¹ and near 1,377 cm⁻¹). Then, the polymer is heat-treated at 350°C for 1 hour to provide a sample having an imidization rate of 100% and its infrared absorption spectrum is observed. Based on a comparison of peak intensities near 1,377 cm⁻¹ measured before heat treatment and those after heat treatment, the imide group content in the resin before heat treatment is calculated and then used to determine the imidization rate.

In 100 mass% of the resin component (organic component excluding the crystalline silica (D) and other inorganic components described later) of the photosensitive resin composition according to the present invention, the polyimide (A) preferably accounts for 20 mass% or more, more preferably 30 mass% or more, and still more preferably 40 mass% or more. A higher content of the amount of the polyimide (A) leads to a film with better film forming properties and a cured product with a higher elastic modulus. On the other hand, in 100 mass% of the resin component in the photosensitive resin composition, the polyimide (A) preferably accounts for 95 mass% or less, more preferably 80 mass% or less, still more preferably 70 mass% or less, and most preferably 60 mass% or less. A lower content of the polyimide (A) allows the cationic polymerization reaction to proceed more smoothly, leading to improved sensitivity during pattern processing and facilitating the formation of a cured product with a higher chemical resistance.

### Cationic polymerizable compound (B)

The photosensitive resin composition according to the present invention includes a cationic polymerizable compound (B). Good substances to use as the cationic polymerizable compound (B) include cyclic ether compounds (such as epoxy compounds and oxetane compounds), ethylenically unsaturated compounds (such as vinyl ethers and styrene compounds), bicycloorthoesters, spiroorthocarbonates, and spiroorthoesters.

Generally known epoxy compounds can be used, and they include aromatic epoxy compounds, alicyclic epoxy compounds, and aliphatic epoxy compounds.

Examples of good aromatic epoxy compounds include glycidyl ethers of monovalent or polyvalent phenols having at least one aromatic ring (such as phenol, bisphenol A, phenol novolac, and alkylene oxide adducts thereof).

Examples of good alicyclic epoxy compounds include compounds obtainable by epoxidizing a compound having at least one cyclohexene or cyclopentene ring using an oxidizing agent (such as 3,4-epoxycyclohexylmethyl-3,4-epoxycyclohexane carboxylate).

Examples of good aliphatic epoxy compounds include polyglycidyl ethers of aliphatic polyhydric alcohols or their alkylene oxide adducts (such as 1,4-butanedioldiglycidyl ether and 1,6-hexanedioldiglycidyl ether), polyglycidyl esters of aliphatic polybasic acids (such as diglycidyl tetrahydrophthalate), and epoxidized long-chain unsaturated compounds (such as epoxidized soybean oil and epoxidized polybutadiene).

Examples of good oxetane compounds include generally known compounds such as 3-ethyl-3-hydroxymethyl oxetane, 2-ethylhexyl(3-ethyl-3-oxetanylmethyl)ether, 2-hydroxyethyl(3-ethyl-3-oxetanylmethyl)ether, 2-hydroxypropyl(3-ethyl-3-oxetanylmethyl)ether, 1,4-bis[(3-ethyl-3-oxetanylmethoxy)methyl] benzene, oxetanyl silsesquioxetane, and phenolnovolac oxetane.

Examples of good ethylenically unsaturated compounds include generally known cationic polymerizable monomers such as aliphatic monovinyl ethers, aromatic monovinyl ethers, polyfunctionalvinyl ethers, styrenes, and cationic polymerizable nitrogen-containing monomers.

Examples of good aliphatic monovinyl ethers include methylvinyl ether, ethylvinyl ether, butylvinyl ether, and cyclohexylvinyl ether.

Examples of good aromatic monovinyl ethers include 2-phenoxyethylvinyl ether, phenylvinyl ether, and p-methoxyphenylvinyl ether.

Examples of good polyfunctional vinyl ethers include butanediol-1,4-divinyl ether and triethylene glycol divinyl ether.

Examples of good styrene compounds include styrene, α-methyl styrene, p-methoxystyrene, and p-(tert-butoxy)styrene.

Examples of good cationic polymerizable nitrogen-containing monomers include N-vinylcarbazol and N-vinylpyrrolidone.

Examples of good bicyclo-orthoesters include 1-phenyl-4-ethyl-2,6,7-trioxabicyclo[2.2.2]octane and 1-ethyl-4-hydroxymethyl-2,6,7-trioxabicyclo-[2.2.2]octane.

Examples of good spiro-orthocarbonates include 1,5,7,11-tetraoxaspiro[5.5]undecane and 3,9-dibenzyl-1,5,7,11-tetraoxaspiro[5.5]undecane.

Examples of good spiro-orthoesters include 1,4,6-trioxaspiro[4.4]nonane, 2-methyl-1,4,6-trioxaspiro[4.4]nonane, and 1,4,6-trioxaspiro[4.5]decane.

These cationic polymerizable compounds (B) may be used singly or as a mixture of two or more thereof.

Of these cationic polymerizable compounds, preferable are epoxy compounds, oxetane compounds, and vinyl ethers; more preferable are epoxy compounds and oxetane compounds; and particularly preferable are epoxy compounds.

These cationic polymerizable compounds are preferably liquid at room temperature (20 degrees). If they are liquid at room temperature, it is preferable because in that case, they are likely to have improved compatibility with the polyimide (A) and show high fine pattern processibility. Furthermore, it is preferable for them to have a functional group equivalent weight of 80 g/eq or more. A larger functional group equivalent weight ensures the formation of a cured product having a higher flexibility. On the other hand, it is preferable for them to have a functional group equivalent weight of 160 g/eq or less, more preferably 130 g/eq or less, and still more preferably 100 g/eq or less. A smaller functional group equivalent weight ensures the formation of a cured product having a higher elastic modulus.

Examples of multifunctional epoxy compounds that are liquid at room temperature and have epoxy equivalent weights of 80 g/eq or more and 160 g/eq or less include TEPIC-VL (trade name, manufactured by Nissan Chemical Corporation), bisphenol A type epoxy compounds, bisphenol F type epoxy compounds, Shofree BATG, and Shofree PETG (trade names, both manufactured by Showa Denko K.K.).

For the present invention, furthermore, the cationic polymerizable compound (B) is preferably an aliphatic compound. If an aliphatic compound is included as the cationic polymerizable compound (B), it allows the refractive index of the resin component to be closer to that of the crystalline silica (D), which will be described later. This allows transparency to be maintained even when the crystalline silica (D) is added as a filler, making it possible to perform fine pattern processing.

Relative to the total mass of the polyimide (A) and the cationic polymerizable compound (B), which accounts for 100 mass%, the cationic polymerizable compound (B) preferably accounts for 30 to 70 mass%. Relative to the total mass of the polyimide (A) and the cationic polymerizable compound (B), which accounts for 100 mass%, the cationic polymerizable compound (B) preferably accounts for 30 mass% or more, more preferably 40 mass% or more. A larger content of the cationic polymerizable compound (B) ensures better cationic curing properties, leading to an increased sensitivity during pattern processing. On the other hand, relative to the total mass of the polyimide (A) and the cationic polymerizable compound (B), which accounts for 100 mass%, the cationic polymerizable compound (B) preferably accounts for 70 mass% or less, more preferably 60 mass% or less. A smaller content of the cationic polymerizable compound (B) leads to better film forming properties and a cured product with a higher elastic modulus. The content of the cationic polymerizable compound (B) is more preferably in the range of 40 to 60 mass%, and in this case, it allows the refractive index of the resin component in the photosensitive resin composition to be closer to that of the crystalline silica (D), which will be described later. This allows transparency to be maintained even when the crystalline silica (D) is added as a filler, making it possible to perform fine pattern processing.

From the perspective of transmittance, relative to the total mass of the cationic polymerizable compound (B), which accounts for 100 mass%, those components of the cationic polymerizable compound (B) that are aliphatic compounds preferably account for 60 mass% or more, more preferably 70 mass% or more, still more preferably 80 mass% or more, and most preferably 90 mass% or more. On the other hand, from the perspective of heat resistance, the cationic polymerizable compound (B) preferably accounts for 90 mass% or less relative to the total mass of the cationic polymerizable compound (B), which accounts for 100 mass%.

### Photocationic polymerization initiator (C)

The photosensitive resin composition according to the present invention includes a photocationic polymerization initiator (C). If a photocationic polymerization initiator (C) is included, it serves to develop a difference in cationic polymerization rate between the light-exposed region and the unexposed region, allowing a desired developer to be used to dissolve the photosensitive resin composition to form a pattern.

Generally known compounds can be used as the photocationic polymerization initiator (C) without specific limitations, but the use of a sulfonium salt is preferable. Specifically, the photocationic polymerization initiator (C) may be, for example, an aromatic iodonium complex salt or an aromatic sulfonium complex salt. Specific examples of the aromatic iodonium complex salt include diphenyliodonium tetrakis(pentafluorophenyl)borate, diphenyliodonium hexafluorophosphate, diphenyliodonium hexafluoroantimonate, and di(4-nonylphenyl)iodonium hexafluorophosphate. For the photocationic polymerization initiator (C), these materials may be used singly or as a mixture of two or more thereof.

Relative to the cationic polymerizable compound (B), which accounts for 100 parts by mass, the photocationic polymerization initiator (C) mentioned above preferably accounts for 0.3 part by mass or more, more preferably 0.5 part by mass or more, and still more preferably 0.7 part by mass or more. This allows the cationic polymerizable compound to show sufficient curing properties to ensure an increased pattern processibility. On the other hand, in order to allow the photosensitive resin composition to have improved storage stability prior to curing, the photocationic polymerization initiator (C) preferably accounts for 15 parts by mass or less, more preferably 10 parts by mass or less, and still more preferably 8 parts by mass or less, relative to the cationic polymerizable compound (B), which accounts for 100 parts by mass.

### Crystalline silica (D)

The photosensitive resin composition according to the present invention includes a crystalline silica (D) as an inorganic filler. The inclusion of a crystalline silica (D), which is an inorganic substance, serves to allow the photosensitive resin composition to form a cured film having an increased elastic modulus, which will show enhanced pressure resistance when used as roofing material for hollow structures. Furthermore, the difference in refractive index between the resin component used for the present invention and the crystalline silica (D) is so small that light scattering will be suppressed and the resolution will be improved. If an amorphous silica is used, on the other hand, the difference in its refractive index from the resin will increase to cause larger light scattering, thereby leading to a reduction in resolution. Furthermore, the crystalline silica (D) is higher in hardness than amorphous silica, and accordingly, the resulting material will show a higher pressure resistance when used as roofing material for hollow structures. The crystalline silica (D) is also higher in heat conductivity than amorphous silica, and accordingly, the resulting material will show enhanced heat dissipation when used as electronic components such as high-frequency filter. In addition, as compared with amorphous silica, the crystalline silica (D) tends to have fewer silanol groups that work to inhibit cationic polymerization. As a result, inhibition of cationic polymerization will not occur during pattern processing, leading to smooth pattern formation.

The presence of the crystalline silica (D) can be examined by performing X-ray diffraction analysis to observe whether crystallinity occurs. Whether it is attributed to silica or other substances can be determined by performing an appropriate composition analysis technique such as X-ray fluorescence analysis.

From the perspective of insulation reliability, the conductivity detected from an extract liquid prepared by extracting the crystalline silica (D) for 20 hours under saturated water vapor pressure conditions at 121°C (121°C-20h conductivity) is preferably 30 µS/cm or less.

It is preferable for the crystalline silica (D) to have an average particle diameter of 0.1 to 3.0 µm. The crystalline silica (D) preferably has an average particle diameter of 0.1 µm or more, more preferably 0.5 µm or more, and still more preferably 0.8 µm or more. A larger average particle diameter serves to decrease the amount of residues more largely during development, leading to an increased resolution. On the other hand, the crystalline silica (D) preferably has an average particle diameter of 3.0 µm or less, more preferably 2.0 µm or less, and still more preferably 1.5 µm or less. A smaller average particle diameter of the crystalline silica (D) serves to form a pattern having a smoother cross section and ensure easier implementation of the subsequent plating step.

In addition, it is preferable for the crystalline silica (D) to have a maximum particle diameter of 0.5 to 9.0 µm. The crystalline silica (D) preferably has a maximum particle diameter of 0.5 µm or more, more preferably 1.5 µm or more, and still more preferably 3.0 µm or more. A larger maximum particle diameter of the crystalline silica (D) serves to decrease the amount of residues more largely during development, leading to an increased resolution. On the other hand, it is preferable for the crystalline silica (D) to have a maximum particle diameter of 9.0 µm or less, more preferably 7.5 µm or less, and still more preferably 6.0 µm or less. A smaller maximum particle diameter serves to form a pattern having a smoother cross section and ensure easier implementation of the subsequent plating step.

For the present invention, the average particle diameter and the maximum particle diameter of the crystalline silica (D) means the 50% volume particle diameter and the 100% volume particle diameter, respectively, that are measured using a particle diameter distribution analyzer operating on the basis of laser diffraction scattering (Microtrac Particle Size Analyzer MODEL MT3000). The measurement is conducted by taking approximately 1 g of a sample and dispersing it in purified water by performing ultrasonic dispersion at 40 W for 1 to 3 minutes. If the particle shape of the crystalline silica (D) is not spherical, the average particle diameter and maximum particle diameter given by the laser diffraction scattering method represent the diameters of volume equivalent spheres. Regardless of the shape of the crystalline silica (D), the average particle diameter and the maximum particle diameter should preferably be within the above ranges. The shape of the crystalline silica (D) may be spherical, needle-like, fibrous, amorphous granular, plate-like, or crushed, and there are no particular limitations.

Relative to the total solid content, which accounts for 100 mass%, in the photosensitive resin composition, it is preferable for the crystalline silica (D) to account for 30 to 80 mass%. From the perspective of improving mechanical properties such as elastic modulus and chemical resistance, the crystalline silica (D) preferably accounts for 30 mass% or more, more preferably 40 mass% or more, still more preferably 50 mass% or more, and most preferably 60 mass% or more, relative to the total solid content, which accounts for 100 mass%, in the photosensitive resin composition. From the perspective of improving the elongation degree, on the other hand, the content of the crystalline silica (D) is preferably 80 mass% or less, more preferably 70 mass% or less, relative to the total solid content, which accounts for 100 mass%, in the photosensitive resin composition.

Furthermore, in order to disperse the crystalline silica (D) in the photosensitive resin composition, surface treatment with a silane coupling agent may be performed if necessary. Thus, it is preferable for the photosensitive resin composition according to the present invention to include a crystalline silica (D) having a surface treated with a silane coupling agent. The silane coupling agent may be a generally known one. In particular, in order to ensure an increased sensitivity during pattern processing without inhibiting the cationic polymerization, it is preferable for the crystalline silica (D) to have a surface treated with a silane coupling agent that has at least one selected from the group consisting of epoxy group, styryl group, isocyanurate group, anhydride groups, carboxylic acid groups, alkyl groups having 1 to 10 carbon atoms, and phenyl group, and it is more preferable to include a phenyl group as functional group. On the other hand, the amino group, mercapto group, and isocyanate group are preferably avoided because they can cause inhibition of cationic curing.

Examples of these preferable silane coupling agents include 2-(3,4-epoxycyclohexyl)ethyltrimethoxysilane (KBM-303), 3-glycidoxypropylmethyldimethoxysilane (KBM-402), 3-glycidoxypropyltrimethoxysilane (KBM-403), 3-glycidoxypropylmethyldiethoxysilane (KBE-402), 3-glycidoxypropyltriethoxysilane (KBE-403), 8-glycidoxyoctyltrimethoxysilane (KBM-4803), p-styryltrimethoxysilane (KBM-1403), tris-(trimethoxysilylpropyl)isocyanurate (KBM-9659), tris-(triethoxysilylpropyl)isocyanurate (KBE-9659), 3-trimethoxysilylpropyl succinic anhydride (X-12-967C), methyltrimethoxysilane (KBM-13), dimethyldimethoxysilane (KBM-22), phenyltrimethoxysilane (KBM-103), dimethoxydiphenylsilane (KBM-202SS), n-propyltrimethoxysilane (KBM-3033), hexyltrimethoxysilane (KBM-3063), decyltrimethoxysilane (KBM-3103C), methylethoxysilane (KBE-13), dimethyldiethoxysilane (KBE-22), phenyltriethoxysilane (KBE-103), n-propyltriethoxysilane (KBE-3033), hexyltriethoxysilane (KBE-3063), and octyltriethoxysilane (KBE-3083), which are manufactured by Shin-Etsu Chemical Co., Ltd. The surface treatment of the crystalline silica (D) can be implemented by dry surface treatment, in which an undiluted liquid or a diluted solution of a silane coupling agent is added to the crystalline silica (D), followed by stirring, or wet surface treatment, in which an undiluted liquid or a diluted solution of a silane coupling agent is added to the crystalline silica (D) dispersed in a solvent, followed by stirring. From the perspective of productivity, it is preferable to adopt dry surface treatment.

### Dispersant (E)

To disperse the crystalline silica (D) in the photosensitive resin composition, it is also preferable to further include a dispersant (E). The dispersant (E) may be a generally known one. In particular, it is preferable for the dispersant (E) to have an amine value of 0 and an acid value of 10 to 400. If the amine value is 0, it serves to improve pattern processibility without inhibiting the cationic polymerization, whereas if the acid value is 10 to 400, it serves to suppress corrosion while improving the dispersion of the crystalline silica (D). Examples of a dispersant with an amine value of 0 include anionic dispersants such as carboxylic acid based dispersants, sulfonic acid based dispersants, sulfate ester based dispersants, and phosphate ester based dispersants, and nonionic dispersants such as ester based dispersants, ether based dispersants, and ester ether based dispersants. Among these, the use of an anionic dispersant is preferable because of being high in adsorptivity to the crystalline silica (D), and in particular, preferable examples include sulfonic acid based dispersants, sulfate ester based dispersants, and phosphate ester based dispersants. If the adsorptivity is high, it allows the crystalline silica (D) to have a higher dispersibility. Furthermore, particles of the crystalline silica (D) can form a network structure via the dispersant (E) to allow the photosensitive resin composition to form a varnish with thixotropy, facilitating the production of a thick photosensitive resin composition film with a stable thickness. Thixotropy of a photosensitive resin composition varnish can be checked by measuring the viscosity at different rotation speeds. If it has thixotropy, the viscosity decreases with an increasing rotation speed. To reduce corrosiveness, it is preferable to adopt a carboxylic acid based dispersant, phosphate ester based dispersant, or nonionic dispersant. Thus, from the perspective of the balance between adsorptivity and corrosiveness, it is most preferable to adopt a phosphate ester based dispersant.

From the perspective of ensuring increased adsorptivity to the crystalline silica (D), it is preferable for the dispersant (E) to have an acid value of 10 or more, more preferably 20 or more, and still more preferably 30 or more. On the other hand, from the perspective of reducing corrosiveness, the acid value of the dispersant (E) is preferably 400 or less, more preferably 200 or less, and still more preferably 100 or less.

From the perspective of ensuring increased dispersibility of the crystalline silica (D) and allowing the photosensitive resin composition varnish to develop thixotropy, it is preferable for the dispersant (E) to have a weight average molecular weight of 5,000 or more, more preferably 10,000 or more, and still more preferably 20,000 or more. On the other hand, the weight average molecular weight of the dispersant (E) is preferably 100,000 or less, more preferably 70,000 or less, and still more preferably 50,000 or less, in order to ensure easy mixing with the coating agent and show good effect as a dispersant.

From the perspective of improving the dispersibility of the crystalline silica (D), the dispersant (E) preferably accounts for 0.05 mass% or more, more preferably 0.10 mass% or more, and still more preferably 0.20 mass% or more, relative to the total solid content, which accounts for 100 mass%, in the photosensitive resin composition. On the other hand, from the perspective of improving the elastic modulus, the dispersant (E) preferably accounts for 2.00 mass% or less, more preferably 1.00 mass% or less, still more preferably 0.50 mass% or less, and most preferably 0.30 mass% or less, relative the total solid content, which accounts for 100 mass%, in the photosensitive resin composition.

The photosensitive resin composition according to the present invention may include a sensitizer in order to absorb ultraviolet light and give the absorbed light energy to the photo acid generator. Preferable sensitizers include, for example, naphthalene compounds having alkoxy groups at the 1- and 4-positions (1,4-dialkoxy-naphthalene derivatives) and anthracene compounds having alkoxy groups at the 9- and 10-positions (9,10-dialkoxy-anthracene derivatives). Examples of good alkoxy groups include those alkoxy groups that have 1 to 4 carbon atoms such as methoxy group, ethoxy group, and propoxy group. The 9,10-dialkoxy-anthracene derivatives may further contain substituent groups. Examples of the substituent groups include halogen atoms such as fluorine atom, chlorine atom, bromine atom, and iodine atom; alkyl groups containing 1 to 4 carbon atoms such as methyl group, ethyl group, and propyl group; and others such as sulfonic acid alkyl ester groups and carboxylic acid alkyl ester groups. Examples of the alkyl groups contained in the sulfonic acid alkyl ester groups and carboxylic acid alkyl ester groups include alkyl groups having 1 to 4 carbon atoms such as methyl, ethyl, and propyl. It is preferable for these substituent groups to be located at the 2-position.

The photosensitive resin composition according to the present invention may include a thermal crosslinking agent, which is preferably a compound having an alkoxymethyl group or a methylol group.

Examples of such a compound having an alkoxymethyl group or a methylol group include DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35 XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, and HMOM-TPPHBA, HMOM-TPHAP (all trade names, manufactured by Honshu Chemical Industry Co., Ltd.), and NIKALAC (registered trademark) MX-290, NIKALAC MX-280, NIKALAC MW-100LM, and NIKALAC MX-750LM (all trade names, manufactured by Sanwa Chemical Co., Ltd.).

The photosensitive resin composition according to the present invention may further include a silane compound. The inclusion of a silane compound serves to improve the adhesion of the photosensitive resin composition. Specific examples of such a silane compound include N-phenylaminoethyl trimethoxysilane, N-phenylaminoethyl triethoxysilane, N-phenylaminopropyl trimethoxysilane, N-phenylaminopropyl triethoxysilane, N-phenylaminobutyl trimethoxysilane, N-phenylaminobutyl triethoxysilane, vinyl trimethoxysilane, vinyl triethoxysilane, vinyl trichlorosilane, vinyl tris-(β-methoxyethoxy)silane, 3-methacryloxypropyl trimethoxysilane, 3-acryloxypropyl trimethoxysilane, p-styryl trimethoxysilane, 3-methacryloxypropylmethyl dimethoxysilane, and 3-methacryloxypropylmethyl diethoxysilane.

In addition, the photosensitive resin composition according to the present invention may contain a surfactant, an ester such as ethyl lactate and propylene glycol monomethylether acetate, an alcohol such as ethanol, a ketone such as cyclohexanone and methylisobutyl ketone, and an ether such as tetrahydrofuran and dioxane, as required for the purpose of improving the adhesion with the substrate.
Furthermore, the photosensitive resin composition according to the present invention may contain an inorganic filler (D') other than the crystalline silica as required, although it is preferably free of such an inorganic filler (D') other than crystalline silica because it is likely to cause reduction in resolution due to light scattering.

There are no specific limitations on the shape of the photosensitive resin composition according to the present invention before curing, and it may be in the form of varnish, film, etc. The photosensitive resin composition according to the present invention is preferably in the form of a film. More specifically, it is preferably in the form of a photosensitive resin composition film that has a photosensitive resin composition coat layer formed from the photosensitive resin composition according to the present invention. Thus, the photosensitive resin composition according to the present invention may be in the form of a film disposed on a support body. More specifically, it may be in the form of a photosensitive resin composition film that contains, on a support body, a photosensitive resin composition coat layer formed from the photosensitive resin composition according to the present invention, although it may be devoid of a support body. When it is to be used in the form of varnish, it can be produced by dissolving the components (A) to (D) and other components as required in an organic solvent. A photosensitive resin composition film can also be produced by, for example, spreading the photosensitive resin composition according to the present invention over a support body and then drying it as required.

Next, methods for preparing a photosensitive resin composition film from the photosensitive resin composition according to the present invention are described below. The photosensitive resin composition film according to the present invention can be produced by spreading a solution (varnish) of the photosensitive resin composition over a support body and then drying it as required. The photosensitive resin composition varnish can be prepared by adding an organic solvent to the photosensitive resin composition. Any appropriate organic solvent can be used here as long as it can dissolve the photosensitive resin composition.

Specific examples of such an organic solvent include ethers such as ethylene glycol monomethyl ether, ethylene glycol monoethyl ether, propylene glycol monomethyl ether, propylene glycol monoethyl ether, ethylene glycol dimethyl ether, ethylene glycol diethyl ether, and ethylene glycol dibutyl ether; acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate, and butyl lactate; ketones such as acetone, methyl ethyl ketone, acetyl acetone, methylpropyl ketone, methylbutyl ketone, methylisobutyl ketone, cyclopentanone, and 2-heptanone; alcohols such as butyl alcohol, isobutyl alcohol, pentanol, 4-methyl-2-pentanol, 3-methyl-2-butanol, 3-methyl-3-methoxybutanol, and diacetone alcohol; aromatic hydrocarbons such as toluene and xylene; and others such as N-methyl-2-pyrrolidone, N-cyclohexyl-2-pyrrolidone, N,N-dimethyl formamide, N,N-dimethyl acetamide, dimethyl sulfoxide, and γ-butyrolactone.

Furthermore, the photosensitive resin composition varnish may be filtrated through a filter paper or other filters. There are no particular limitations on the filtering method to use, but it is preferable to perform filtration under pressure using a filter with a particle retention diameter of 0.4 µm to 10 µm.

The photosensitive resin composition film according to the present invention is preferably disposed on a support body when in use. There are no particular limitations on the support body, and various useful films are commercially available including polyethylene terephthalate (PET) film, polyphenylene sulfide film, and polyimide film. The surface of the support body to be adhered to the photosensitive resin composition film may be surface-treated with silicone, silane coupling agent, aluminum chelating agent, polyurea, or the like in order to ensure strong contact and easy peeling. Furthermore, although there are no particular limitations on the thickness of the support body, it is preferably in the range of 10 to 100 µm from the viewpoint of workability.

In addition, the photosensitive resin composition film according to the present invention may have a protection film thereon to protect the surface. This serves to protect the surface of the photosensitive resin composition film from contaminants such as dirt and dust in the air. There are no particular limitations on the protection film, but preferable ones include polyester films, such as polyethylene terephthalate (PET) films, and polyolefin films. It is preferable for such a protection film to be small in adhesiveness to the photosensitive resin composition film.

Good methods to use to spread the photosensitive resin composition varnish over a support body include spin coating using a spinner, spray coating, roll coating, screen printing, and coating techniques using a blade coater, die coater, calender coater, meniscus coater, bar coater, roll coater, comma roll coater, gravure coater, screen coater, slit die coater, or the like. Furthermore, although the required coating film thickness varies depending on the coating technique used, the solid content and viscosity of the composition, and the like, it is commonly preferable for the resulting dried film to have a thickness of 0.5 µm or more and 100 µm or less.

Drying can be carried out by using an oven, hot plate, infrared light, or the like. The drying temperature and drying period may be set as desired as long as the organic solvent can be volatilized, but it is preferable to set them in appropriate ranges so as to bring the photosensitive resin composition film into an uncured or semicured state. Specifically, it is preferable to maintain a temperature in the range of 40°C to 120°C for 1 minute to several tens of minutes. It may also be good to adopt a combination of different temperatures in this range to perform heating in stages. For example, heat treatment may be performed at 70°C, 80°C, and 90°C for 1 minute at each of the temperatures.

Next, pattern processing methods to use for the photosensitive resin composition varnish according to the present invention or for a photosensitive resin composition film prepared therefrom and methods to use for their thermocompression bonding to other members will be described with reference to examples.

Described first are methods to form a photosensitive resin composition coat layer on a substrate using the photosensitive resin composition according to the present invention or a photosensitive resin composition film prepared therefrom. When the photosensitive resin composition varnish is used, the varnish is spread over a substrate first. Useful coating methods include spin coating using a spinner, spray coating, roll coating, and screen printing. Furthermore, although the required coating film thickness varies depending on the coating technique used, the solid content and viscosity of the photosensitive resin composition, and the like, it is commonly preferable for the varnish to be applied so that the film thickness after drying will be 0.5 µm or more and 100 µm or less. Next, the substrate coated with the photosensitive resin composition varnish is dried to form a photosensitive resin composition coat layer. Drying can be carried out by using an oven, hot plate, infrared ray, or the like. The drying temperature and drying period may be set as desired as long as the organic solvent can be volatilized, but it is preferable to set them in appropriate ranges so as to bring the photosensitive resin composition coat layer into an uncured or semicured state. Specifically, it is preferable to maintain a temperature in the range of 50°C to 150°C for 1 minute to several hours.

On the other hand, in the case where a photosensitive resin composition film is used, the protection film, if any, is peeled off first, and then the photosensitive resin composition film and a substrate are disposed in such a manner that they face each other, followed by combining them by thermocompression bonding to form a photosensitive resin composition coat layer. Thermocompression bonding can be carried out by hot pressing treatment, thermal lamination treatment, thermal vacuum lamination treatment, or the like. The combining temperature is preferably 40°C or more from the viewpoint of the adhesion properties to the substrate and embedding properties. On the other hand, the combining temperature is preferably 150°C or less in order to prevent the photosensitive resin composition film from being cured during the combining step to cause a decrease in resolution when forming a pattern in the light irradiation and development steps.

In any case, useful materials for such a substrate include silicon wafers, various ceramic substrates, gallium arsenide substrate, organic material based circuit boards, inorganic material based circuit boards, and such boards provided with circuit components arranged thereon, although the substrate is not limited thereto. Examples of organic material based circuit boards include glass base copper clad laminates such as glass cloth/epoxy copper clad laminates, composite copper clad laminates such as glass nonwoven fabric/epoxy copper clad laminates, heat resistant thermoplastic substrates such as polyetherimide resin substrates, polyetherketone resin substrates, and polysulfone based resin substrates, and flexible substrates such as polyester copper clad film substrates and polyimide copper clad film substrates. On the other hand, examples of inorganic material based circuit boards include ceramic substrates such as alumina substrates, aluminum nitride substrates, and silicon carbide substrates, and metal substrates such as aluminum base substrates and iron base substrates. Examples of materials to use for producing circuit components include conductors containing metals such as silver, gold, and copper, resistors containing inorganic oxides, low dielectric materials containing glass based materials and/or resins, high dielectric materials containing resins, high dielectric inorganic particles, etc., and insulators containing glass based materials.

Then, an actinic ray is applied to the photosensitive resin composition coat layer formed by a method as described above through a mask having an intended pattern to carry out light exposure. There are various useful actinic rays for light exposure including ultraviolet ray, visible light, electron beam, and X-ray, but the use of i-line (365 nm), h-line (405 nm), or g-line (436 nm) of a mercury lamp is preferable for the present invention. In the case where the photosensitive resin composition film in use has a support body that is transparent to these rays, light exposure can be carried out without peeling off the support body from the photosensitive resin composition film.

To produce a pattern, the light exposure step is followed by removing the exposed portion using a developer. Preferable developers include aqueous solutions of tetramethyl ammonium hydroxide and aqueous solutions of alkaline compounds such as diethanolamine, diethyl aminoethanol, sodium hydroxide, potassium hydroxide, sodium carbonate, potassium carbonate, triethyl amine, diethyl amine, methyl amine, dimethyl amine, dimethylaminoethyl acetate, dimethylaminoethanol, dimethylaminoethyl methacrylate, cyclohexyl amine, ethylene diamine, and hexamethylene diamine. In some cases, these aqueous alkali solutions may contain polar solvents such as N-methyl-2-pyrrolidone, N,N-dimethylformamide, N,N-dimethylacetamide, dimethyl sulfoxide, γ-butyrolactone, and dimethylacrylamide; alcohols such as methanol, ethanol, and isopropanol; esters such as ethyl lactate and propylene glycol monomethyl ether acetate; and ketones such as cyclopentanone, cyclohexanone, isobutyl ketone, and methylisobutyl ketone; which may be contained singly or as a combination of several ones thereof.

Development can be carried out by spraying a developer described above on the coat surface, covering the entire coat surface with a developer, immersing it in a developer, or applying supersonic waves to immersed surface. The development conditions such as development time and the temperature of the developer solution used in the development step may be set up appropriately at least in such a manner that the exposed portions are removed to realize pattern formation.

Rinsing with water is preferably performed after the development step. Here again, rinsing may be performed with a solution prepared by adding to water an alcohol such as ethanol and isopropyl alcohol or an ester such as ethyl lactate and propylene glycol monomethyl ether acetate.

Furthermore, baking may be performed as required before development. In some cases, this can serve to form a pattern with an increased resolution after development and widen the tolerance range of the development conditions. It is preferable for this baking treatment to be perform in the temperature range of 50°C to 180°C, more preferably 60 °C to 120°C in particular. The treatment time is preferably 5 seconds to several hours.

After the pattern formation step, unreacted portions of the cationic polymerizable compound and cationic polymerization initiator are likely to remain in the photosensitive resin composition coat layer. Accordingly, these are likely to be thermally decomposed during thermocompression bonding or curing to generate gas. To avoid this, it is preferable to irradiate the entire surface of the photosensitive resin composition coat layer with the aforementioned exposure light after the pattern formation step to ensure the complete generation of acid from the cationic polymerization initiator. By doing so, the reaction of the unreacted portions of the cationic polymerizable compound proceeds during thermocompression bonding or curing, thereby suppressing the generation of gas attributable to thermal decomposition.

After the development step, heating is performed at a temperature of 150°C to 500°C to cause a thermal crosslinking reaction. This crosslinking serves to realize an increase in heat resistance and chemical resistance. This heat treatment may be performed by any of appropriate methods such as stepwise heating at selected temperatures and continuous heating-up for 5 minutes to 5 hours over an appropriately selected temperature range. As an example of the former method, heat treatment is performed at 130°C and 200°C for 30 minutes at each temperature. As an example of the latter method, heating may be performed for 2 hours in such a manner that the temperature is increased linearly from room temperature to 400°C.

In the photosensitive resin composition film according to the present invention, it is preferable for the visible light transmittance at a depth of 30 µm in the thickness direction into the photosensitive resin composition coat layer to be 70% or more and 100% or less, more preferably 80% or more and 100% or less, and still more preferably 90% or more and 100% or less. If the visible light transmittance in the photosensitive resin composition coat layer is 70% or more and 100% or less, it facilitates the photomask positioning and the formation of the roof member of a hollow structure because the marks used for the positioning on the substrate can be highly visible in the steps for photomask positioning and light exposure. To determine the visible light transmittance, the transmittance of light in the wavelength range of 400 to 800 nm is measured using an ultraviolet-visible spectrophotometer and averaging the measured values.

Furthermore, in the photosensitive resin composition coat layer in the photosensitive resin composition film according to the present invention, it is preferable for the 365 nm light transmittance at a depth of 30 µm to be 30% or more, more preferably 40% or more, still more preferably 50% or more, and most preferably 60% or more. As the light transmittance at a wavelength of 365 nm increases, the light beam is more likely to reach the bottom of the pattern, and accordingly, the formation of a thicker pattern becomes possible. On the other hand, the light transmittance at a wavelength of 365 nm at a depth of 30 µm in the photosensitive resin composition coat layer is preferably 80% or less. As the light transmittance at a wavelength of 365 nm in the photosensitive resin composition coat layer decreases, the sensitivity of the photosensitive resin composition coat layer can become higher.

### Cured product and hollow structure

The cured product according to the present invention is one produced by heat-curing either the photosensitive resin composition according to the present invention or the photosensitive resin composition coat layer in the photosensitive resin composition film according to the present invention.

The cured product according to the present invention can be suitably used as the roof member of a structure having a hollow portion (hereinafter referred to as a hollow structure). Thus, the hollow structure preferably has a roof member made of the cured product according to the present invention. The hollow structure is a structure that includes a recessed or protruded portion disposed in an electronic component along with a roof member, which is formed by thermocompression-bonding the photosensitive resin composition film according to the present invention to the recessed or protruded portion. Subsequently, as required, unnecessary portions may be removed by performing the aforementioned pattern processing method and then heat treatment is carried out to complete the roof member of the hollow structure. It is preferable for the roof member of the hollow structure according to the present invention to have a thickness of 10 µm or more and 100 µm or less. If the roof member has a thickness of 10 µm or more, it is preferable because it allows the roof member to have an increased film strength in the intended hollow structure, and it is more preferably 25 µm or more, still more preferably 35 µm or more, and most preferably 45 µm or more. On the other hand, the roof member preferably has a thickness of 100 µm or less because it allows the hollow structure to be thinner to contribute to the production of a smaller electronic component, and it is more preferably 80 µm or less, still more preferably 60 µm or less.

Furthermore, the hollow structure having the cured product according to the present invention is preferably sealed with a molding resin to allow the electronic component to have a higher robustness. Thus, it is preferable for the hollow structure according to the present invention to have an outer periphery sealed with a molding resin. The sealing of the outer periphery of the hollow structure with a molding resin can be commonly carried out by the transfer molding technique, the compression molding technique, etc.

The elastic modulus at 180°C (hereinafter the elastic modulus at 180°C is referred to as 180°C elastic modulus) of the cured product according to the present invention is preferably 4 GPa or more, more preferably 5 GPa or more, still more preferably 6 GPa or more, and particularly preferably 7 GPa or more. If it has a 180°C elastic modulus of 4 GPa or more, it will withstand the sealing step more easily when used as a roofing material. On the other hand, from the viewpoint of suppression of cracking, the 180°C elastic modulus of the cured product is preferably 20 GPa or less, more preferably 16 GPa or less, and still more preferably 12 GPa or less. The 180°C elastic modulus can be measured using a dynamic viscoelasticity measuring device.

Such a molding process as described above can be realized by pouring a sealing resin, which is melted at a temperature of about 180°C, into the space around the electronic component under a pressure of about 6 MPa. Thus, during this sealing step, the roof member of the hollow structure is subjected to a pressure of about 6 MPa at a high temperature. If the cured product used to form the roof member of the hollow structure is low in film strength, it may lead to deformation and destruction of the roof member of the structure. In this regard, this hollow structure, i.e., a hollow structure having a roof member made of the cured product according to the present invention, has a sufficient film strength to serve for improving the yield of the electronic component in the step for sealing with a molding resin.

The applications of the cured product according to the present invention are not particularly limited, and it can be applied to a wide range of uses such as surface protection films and interlayer insulation films in component mounting boards, substrates for systems using semiconductors such as wafer-level packages, etc., resist for wiring protection and insulation films on circuit boards, and various other electronic components and devices. In addition, due to its high heat resistance, it is particularly suitable for use as permanent resist, that is, adhesive for thermocompression bonding of an adherend to a patterned interlayer insulation film, substrate after pattern formation, glass, semiconductor element, etc.

### Electronic components

The cured product according to the present invention is suitably used for electronic components, and particularly suitable high frequency filters to contain the cured product according to the present invention include SAW filters and BAWfilters. Because of being high in pattern processibility and able to form highly reliable insulating films, the cured product according to the present invention can be suitably used also for components other than such electronic components having hollow structures.

It is preferable for an electronic component according to the present invention to have a hollow structure provided with a roof member made of the cured product according to the present invention. Particularly suitable electronic components having hollow structures include high frequency filters. On the other hand, in addition to high frequency filters, the hollow structure according to the present invention can also be applied to other devices such as crystal oscillators.

### EXAMPLES

The present invention will be illustrated in detail below with reference to examples, though the invention is not limited thereto.

### <Surface treatment of crystalline silica (D)>

The crystalline silica (D) was fed to a mixer and stirred at 6,000 rpm for 30 seconds, and then a silane coupling agent was added as a surface treatment agent. Then, stirring was continued at 6,000 rpm for 3 minutes to ensure surface treatment of the crystalline silica (D). The amount S of the silane coupling agent added was as calculated by the following formula: S = (α×β)/γ

Here, α is the mass of the crystalline silica; β is the specific surface area of the crystalline silica; and γ is the minimum covering area of the silane coupling agent.

### <Measurement of weight average molecular weight of dispersant (E)>

The weight average molecular weight of each dispersant (E) was measured by GPC, and the measured value was taken as the weight average molecular weight of the dispersant (E). The measuring conditions adopted were as described below.
Device: e2695-2998 (manufactured by Nihon Waters K.K.)
Column: G4000 HXL + G1000 HXL (manufactured by Tosoh Corporation)
Column temperature: 30°C
Eluent: tetrahydrofuran
Flow rate: 1 ml/min
Standard substance: polystyrene
Detection wavelength: 254 nm

### <Thixotropy of photosensitive resin composition varnish>

Before the film formation step, the photosensitive resin composition varnish was examined using an E-type viscometer (RE215L, manufactured by Toki Sangyo Co., Ltd.) to measure the viscosity A at a rotation speed of 0.1 rpm and the viscosity B at a rotation speed of 0.2 rpm. The thixotropy was evaluated according to the following criteria.
∘: Viscosity A/Viscosity B is 1.3 or more. Thixotropic.
△: Viscosity A/Viscosity B is 1.1 or more and less than 1.3. Slightly thixotropic.
×: Viscosity A/Viscosity B is less than 1.1. Not thixotropic.

### <Thickness variation of photosensitive resin composition coat layer>

The thickness of the photosensitive resin composition coat layer in a photosensitive resin composition film (excluding the protection film and support film) was measured at 5 points located at intervals of 5 cm. The difference of (maximum thickness) - (minimum thickness) was calculated and it was taken to represent the thickness variation. A smaller difference of (maximum thickness) - (minimum thickness) indicates that the thickness is stable, which is more desirable.

### <Dispersity of crystalline silica (D)>

A 10 cm square specimen was cut out of a photosensitive resin composition film and observed under a microscope. The dispersity of the crystalline silica (D) was evaluated according to the following criteria:
o: No aggregates. The crystalline silica (D) is highly dispersed.
×: Aggregates present. The crystalline silica (D) is poorly dispersed.

### <Evaluation for resolution>

After peeling off the protection film, the photosensitive resin composition film was placed in such a manner that the photosensitive resin composition coat layer faced a silicon wafer. Then, it was roll-laminated onto a 4-inch silicon wafer under the conditions of 80°C and 0.3 MPa. A photomask having 20 via patterns having diameters of 5, 10, 15, up to 100 µm in 5 µm increments was placed on the photosensitive resin composition film (a layered body formed of a support film and a photosensitive resin composition coat layer), and then, it was exposed to light of 400 mJ/cm² (in terms of i-line, full wavelength exposure) using an exposure machine having a super high pressure mercury lamp as light source. After light exposure, the support film was peeled off and heating was performed on a hot plate at 90°C for 10 minutes. Subsequently, using a 2.38 mass% aqueous solution of tetramethylammonium hydroxide, shower development was performed for 180 seconds to remove unexposed regions, followed by rinsing with water for 60 seconds and then spin-drying. In addition, heat treatment was carried out at 200°C for 60 minutes in an inert oven and consequently, a cured product with via patterns was formed on a silicon wafer. The via patterns were observed under a microscope, and the size of the smallest of the fully open vias was taken to represent the resolution. A smaller open hole size ensures higher resolution.

### <Evaluation of 180°C elastic modulus of cured product>

After peeling off the protection film, the photosensitive resin composition film was placed in such a manner that the photosensitive resin composition coat layer faced a silicon wafer. Then, it was roll-laminated onto a 4-inch silicon wafer under the conditions of 80°C and 0.3 MPa. The support film and photosensitive resin composition coat layer were exposed to light to 400 mJ/cm² (using i-line cut filter, in terms of h-line) using an exposure machine having a super high pressure mercury lamp as light source. After light exposure, the support film was peeled off and heat treatment was carried out at 200°C for 60 minutes in an inert oven. Thus, a cured product was formed on the silicon wafer. Then, the resulting cured film was removed from the silicon wafer to create a single layer cured product. This single layer film was cut into a 5 mm × 40 mm sample with a single edged knife, and its elastic modulus was measured at 180°C using a dynamic viscoelasticity measuring device (DMS6100, manufactured by Hitachi High-Tech Science Corporation). Here, the measurement for this cured product was carried out under the following conditions: test mode of "tensile", test temperature of from room temperature (23°C) to 350°C, heating rate of 5°C/min, test frequency of 1 Hz, chuck distance of 10 mm, and sample width of 5 mm. The 180°C elastic modulus obtained was taken as evaluation result. A higher 180°C elastic modulus is more desirable.

### <Evaluation for visible light transmittance and 365 nm transmittance (transmittance at wavelength of 365 nm) of photosensitive resin composition coat layer>

The protection film was peeled off from a photosensitive resin composition film to provide a sample for evaluation. This sample was examined using a ultraviolet-visible spectrophotometer (U-3900, manufactured by Hitachi High-Tech Science Corporation) to measure its transmittance at wavelengths of 350 to 800 nm. To determine the visible light transmittance, the transmittance of light in the wavelength range of 400 to 800 nm was measured and averaged. Here, this measurement was carried out under the following conditions: support film used as reference, scan speed of 300 nm/min, and sampling interval of 0.5 nm. Specifically, the difference between the value of the evaluation sample and the value of the reference (support film) is calculated to determine the visible light transmittance and 365 nm transmittance of the photosensitive resin composition coat layer. A higher light transmittance is more desirable.

### <Polyimide (A)>

A-1:
   An alkali soluble polyimide having a carboxylic acid residue at a molecular chain end synthesized by the method described was used.
   In a dry nitrogen flow, 2,2-bis(3-amino-4-hydroxyphenyl)hexafluoropropane (hereinafter referred to as BAHF) (22.25 g, 0.09 mol) was added to 80 g of GBL and stirred at 120°C to ensure dissolution. Then, 4-(2,5-dioxotetrahydrofuran-3-yl)-1,2,3,4-tetrahydronaphthalene-1,2-dicarboxylic dianhydride (30.03 g, 0.1 mol) was added along with 20 g of GBL and the mixture was stirred at 120°C for 1 hour and then stirred at 200°C for 4 hours to provide a reaction solution. Next, the reaction solution was poured in 3 L of water and the resulting white precipitate was collected. This precipitate was collected by filtration, rinsed with water three times, and dried in a vacuum dryer at 80°C for 5 hours. The solubility of the polyimide A-1 in an aqueous solution of tetramethylammonium (2.38 mass%) at 23°C was not less than 0.1 g/100 g.
A-2:
   An alkali soluble polyimide having a carboxylic acid residue at a molecular chain end synthesized by the method described was used.

In a dry nitrogen flow, BAHF (22.25g, 0.09 mol) was added to 80 g of GBL and stirred at 120°C to ensure dissolution. Then, norbornane-2-spiro-2'-cyclohexanone-5'-spiro-2"-norbornane-5,5",6,6"-tetracarboxylic dianhydride (38.44 g, 0.1 mol) was added along with 20 g of GBL and the mixture was stirred at 120°C for 1 hour and then stirred at 200°C for 4 hours to provide a reaction solution. Next, the reaction solution was poured in 3 L of water and the resulting white precipitate was collected. This precipitate was collected by filtration, rinsed with water three times, and dried in a vacuum dryer at 80°C for 5 hours. The solubility of the polyimide A-2 in an aqueous solution of tetramethylammonium (2.38 mass%) at 23°C was not less than 0.1 g/100 g.

### <Cationic polymerizable compound (B)>

PETG (pentaerythritol tetraglycidyl ether, manufactured by Showa Denko K.K.), liquid at room temperature, aliphatic compound, epoxy equivalent weight = 90 g/eq
BATG (2,2'-diglycidyl bisphenol A diglycidyl ether, manufactured by Showa Denko K.K.), liquid at room temperature, aromatic compound, epoxy equivalent weight = 113 g/eq

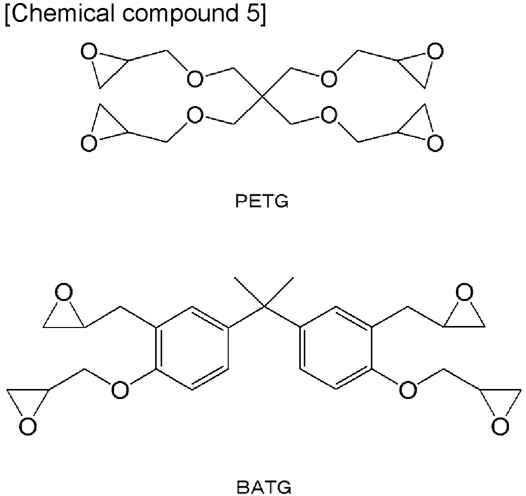

### <Photocationic polymerization initiator (C)>

CPI-310FG (sulfonium salt based photo acid generator, manufactured by San-Apro Ltd.)

### <Crystalline silica (D)>

Crystalline silica-1 (average particle diameter 0.7 µm, maximum particle diameter 2.8 µm, specific surface area 28 m²/g, 121°C-20h conductivity 23 µS/cm)
Crystalline silica-2 (average particle diameter 1.1 µm, maximum particle diameter 3.9 µm, specific surface area 10 m²/g, 121°C-20h conductivity 17 µS/cm)
Crystalline silica-3 (average particle diameter 1.6 µm, maximum particle diameter 4.6 µm, specific surface area 7 m²/g, 121°C-20h conductivity 19 µS/cm)
Crystalline silica-4 (average particle diameter 2.1 µm, maximum particle diameter 6.5 µm, specific surface area 5 m²/g, 121°C-20h conductivity 19 µS/cm)

Here, the 121°C-20h conductivity means the conductivity detected from an extract liquid prepared by extracting crystalline silica for 20 hours under saturated water vapor pressure conditions at 121°C (121°C-20h conductivity).

### <(D') Inorganic filler other than crystalline silica>

Amorphous silica-1 (SO-E2, manufactured byAdmatechs Co., Ltd., average particle diameter 0.5 µm, maximum particle diameter 2.0 µm)
Glass-1 (glass containing 45 mass% silicon oxide, 25 mass% aluminum oxide, 4 mass% boron oxide, and 26 mass% yttrium oxide, average particle diameter 1.6 µm, maximum particle diameter 5.5 µm).

### <Surface treatment agent for filler>

KBM-3063 (hexyltrimethoxysilane, manufactured by Shin-Etsu Chemical Co., Ltd., minimum covering area 378 m²/g)
KBM-103 (phenoltrimethoxysilane, manufactured by Shin-Etsu Chemical Co., Ltd., minimum covering area 393 m²/g)
KBM-403 (3-glycidoxypropyl trimethoxysilane, manufactured by Shin-Etsu Chemical Co., Ltd., minimum covering area 330 m²/g)
KBM-303 (2-(3,4-epoxycyclohexyl)ethyl trimethoxysilane, manufactured by Shin-Etsu Chemical Co., Ltd., minimum covering area 317 m²/g)

### <Dispersant (E)>

GW-1500 (carboxylic acid based dispersant, manufactured by Kyoeisha Chemical Co., Ltd., amine value 0, acid value 55, weight average molecular weight 5,000)
BYK-P105 (carboxylic acid based dispersant, manufactured by BYK Japan KK, amine value 0, acid value 365, weight average molecular weight 70,000)
DISPERBYK-111 (phosphate ester based dispersant, manufactured by BYK Japan KK, amine value 0, acid value 125, weight average molecular weight 6,000)
ED153 (phosphate ester based dispersant, manufactured by Kusumoto Chemicals, Ltd., amine value 0, acid value 55, weight average molecular weight 40,000)

### <Sensitizer>

UVS-2171 (1,4-diethoxynaphthalene, manufactured by Shin-Etsu Chemical Co., Ltd.)

### Example 1

To GBL, A-1 (30 g) was added as the component (A), PETG (18 g) and BATG (12 g) as the component (B), CPI-310B (2 g) as the component (C), non-surface-treated crystalline silica-2 (16 g) as the component (D), and UVS-2171 (0.6 g) as a sensitizer. The amount of the solvent to be added was controlled in such a manner that the solid content was 60 mass%, wherein the solid content means the total content of all components excluding the solvent. Then, the mixture was stirred at room temperature for 120 minutes to dissolve the resin components. The resulting solution was subjected to pressure filtration through a filter with a particle retention diameter of 10 µm to provide a photosensitive resin composition varnish.

The resulting photosensitive resin composition varnish was spread on a PET film with a thickness of 50 µm using a comma roll coater, dried at 120°C for 8 minutes to form a photosensitive resin composition coat layer, and laminated at 100°C with a 25 µm thick PET film as protection film to provide a photosensitive resin composition film. The thickness of the resin composition film coat layer was adjusted to 30 µm. The resulting photosensitive resin composition film was evaluated by the methods described above for resolution, 180°C elastic modulus, visible light transmittance, and 365 nm transmittance. Results are shown in Tables.

### <Examples 2 to 15 and Comparative examples 1 to 3>

In Examples 2 to 15 and Comparative Examples 1 to 3, the same procedure as in Example 1 was carried out except for using the components shown in Tables instead of the components used in Example 1 to prepare photosensitive resin composition films. The resulting photosensitive resin composition films were evaluated by the methods described above for resolution, 180°C elastic modulus, visible light transmittance, and 365 nm transmittance. Evaluation results obtained in Examples 2 to 15 and Comparative Examples 1 to 3 are shown in Tables.

### Examples 16 to 25

In Examples 16 to 25, the same procedure as in Example 1 was carried out except for using the components shown in Tables instead of the components used in Example 1 and adjusting the thickness of the photosensitive resin composition coat layers to 50 µm to prepare photosensitive resin composition varnishes and photosensitive resin composition films. The resulting photosensitive resin composition varnishes were evaluated for thixotropy by the method described above, whereas the resulting photosensitive resin composition films were evaluated for thickness variation, dispersity of the crystalline silica (D), and 180°C elastic modulus by the methods described above. Evaluation results obtained in Examples 16 to 25 are shown in Tables.

### [Table 1]

**[Table 1]**

| | | Examples | | | | | |
|---|---|---|---|---|---|---|---|
| | | 1 | 2 | 3 | 4 | 5 | 6 |
| component (A) | A-1 [g] | 30 | 30 | 30 | 30 | 30 | 30 |
| | A-2 [g] | | | | | | |
| component (B) | PETG [g] | 18 | 18 | 18 | 18 | 18 | 18 |
| | BATG [g] | 12 | 12 | 12 | 12 | 12 | 12 |
| component (C) | CPI-310FG [g] | 2 | 2 | 2 | 2 | 2 | 2 |
| component (D) | crystalline silica-1 [g] | | | | | 42 | |
| | crystalline silica-2 [g] | 16 | 42 | 63 | 94 | | |
| | crystalline silica-3 [g] | | | | | | 42 |
| | crystalline silica-4 [g] | | | | | | |
| | surface treatment | | | | | | |
| component (D') | amorphous silica-1 | | | | | | |
| | glass-1 | | | | | | |
| sensitizer | UVS-2171 | 0.6 | 0.6 | 0.6 | 0.6 | 0.6 | 0.6 |
| component (B) / {component (A)+component (B)} [mass%] | | 50 | 50 | 50 | 50 | 50 | 50 |
| content of aliphatic compound in component (B) [mass%] | | 60 | 60 | 60 | 60 | 60 | 60 |
| content of filler [mass%] | | 20 | 40 | 50 | 60 | 40 | 40 |
| resolution [um] | | 25 | 30 | 30 | 40 | 40 | 30 |
| 180°C elastic modulus [GPa] | | 3.5 | 5.5 | 6.5 | 9.0 | 5.5 | 5.5 |
| visible light transmittance [%] | | 97 | 95 | 93 | 93 | 94 | 95 |
| 365 nm transmittance [%] | | 51 | 44 | 42 | 39 | 48 | 38 |

### [Table 2]

**[Table 2]**

| | | Examples | | | | | |
|---|---|---|---|---|---|---|---|
| | | 7 | 8 | 9 | 10 | 11 | 12 |
| component (A) | A-1 [g] | 30 | | 30 | 30 | 30 | 30 |
| | A-2 [g] | | 30 | | | | |
| component (B) | PETG [g] | 18 | 18 | 12 | 24 | 30 | 18 |
| | BATG [g] | 12 | 12 | 18 | 6 | 0 | 12 |
| component (C) | CPI-310FG [g] | 2 | 2 | 2 | 2 | 2 | 2 |
| component (D) | crystalline silica-1 [g] | | | | | | |
| | crystalline silica-2 [g] | | 42 | 42 | 42 | 42 | 42 |
| | crystalline silica-3 [g] | | | | | | |
| | crystalline silica-4 [g] | 42 | | | | | |
| | surface treatment | | | | | | KBM-3063 |
| component (D') | amorphous silica-1 | | | | | | |
| | glass-1 | | | | | | |
| sensitizer | UVS-2171 | 0.6 | 0.6 | 0.6 | 0.6 | 0.6 | 0.6 |
| component (B) / {component (A)+component (B)} [mass%] | | 50 | 50 | 50 | 50 | 50 | 50 |
| content of aliphatic compound in component (B) [mass%] | | 60 | 60 | 40 | 80 | 100 | 60 |
| content of filler [mass%] | | 40 | 40 | 40 | 40 | 40 | 40 |
| resolution [um] | | 30 | 40 | 40 | 25 | 20 | 30 |
| 180°C elastic modulus [GPa] | | 5.5 | 5.5 | 5.5 | 5.7 | 5.9 | 5.5 |
| visible light transmittance [%] | | 94 | 88 | 83 | 88 | 87 | 95 |
| 365 nm transmittance [%] | | 37 | 35 | 28 | 60 | 76 | 40 |

### [Table 3]

**Table 3]**

| | | Examples | | | Comparative examples | | |
|---|---|---|---|---|---|---|---|
| | | 13 | 14 | 15 | 1 | 2 | 3 |
| component (A) | A-1 [g] | 30 | 30 | 30 | 30 | 30 | 30 |
| | A-2 [g] | | | | | | |
| component (B) | PETG [g] | 18 | 18 | 18 | 18 | 18 | 18 |
| | BATG [g] | 12 | 12 | 12 | 12 | 12 | 12 |
| component (C) | CPI-310FG [g] | 2 | 2 | 2 | 2 | 2 | 2 |
| component (D) | crystalline silica-1 [g] | | | | | | |
| | crystalline silica-2 [g] | 42 | 42 | 42 | | | |
| | crystalline silica-3 [g] | | | | | | |
| | crystalline silica-4 [g] | | | | | | |
| | surface treatment | KBM-103 | KBM-403 | KBM-303 | | | |
| component (D') | amorphous silica-1 | | | | | 42 | |
| | glass-1 | | | | | | 42 |
| sensitizer | UVS-2171 | 0.6 | 0.6 | 0.6 | 0.6 | 0.6 | 0.6 |
| component (B) / {component (A)+component (B)} [mass%] | | 50 | 50 | 50 | 50 | 50 | 50 |
| content of aliphatic compound in component (B) [mass%] | | 60 | 60 | 60 | 60 | 60 | 60 |
| content of filler [mass%] | | 40 | 40 | 40 | 0 | 40 | 40 |
| resolution [um] | | 25 | 30 | 30 | 15 | peeled | no vias |
| 180°C elastic modulus [GPa] | | 5.5 | 5.5 | 5.5 | 2.0 | 5.1 | 5.5 |
| visible light transmittance [%] | | 94 | 94 | 94 | 98 | 8 | 30 |
| 365 nm transmittance [%] | | 55 | 41 | 39 | 55 | 0 | 17 |

### [Table 4]

**[Table 4]**

| | | Examples | | | | | |
|---|---|---|---|---|---|---|---|
| | | 16 | 17 | 18 | 19 | 20 | 21 |
| component (A) | A-1 [g] | 30 | 30 | 30 | 30 | 30 | 30 |
| component (B) | PETG [g] | 18 | 18 | 18 | 18 | 18 | 18 |
| | BATG [g] | 12 | 12 | 12 | 12 | 12 | 12 |
| component (C) | CPI-310FG [g] | 2 | 2 | 2 | 2 | 2 | 2 |
| component (D) | crystalline silica-2 [g] | 41 | 42 | 42 | 42 | 41 | 41 |
| component (E) | GW-1500 [g] | | 0.27 | | | | |
| | BYK-P 105 [g] | | | 0.27 | | | |
| | DISPERBYK-111 [g] | | | | 0.27 | | |
| | ED153 [g] | | | | | 0.09 | 0.18 |
| component (B) / {component (A)+component (B)} [mass%] | | 50 | 50 | 50 | 50 | 50 | 50 |
| content of aliphatic compound in component (B) [mass%] | | 60 | 60 | 60 | 60 | 60 | 60 |
| content of filler [mass%] | | 40 | 40 | 40 | 40 | 40 | 40 |
| content of component (E) [mass%] | | 0 | 0.26 | 0.26 | 0.26 | 0.09 | 0.17 |
| thixotropy | | × | × | × | △ | △ | ○ |
| film thickness variation [µm] | | 5.1 | 5.1 | 5.0 | 2.5 | 2.4 | 0.8 |
| dispersibility of crystalline silica (D) | | × | ○ | ○ | ○ | ○ | ○ |
| 180°C elastic modulus [GPa] | | 5.5 | 5.5 | 5.5 | 5.5 | 5.5 | 5.5 |

### [Table 5]

**[Table 5]**

| | | Examples | | | |
|---|---|---|---|---|---|
| | | 22 | 23 | 24 | 25 |
| component (A) | A-1 [g] | 30 | 30 | 30 | 30 |
| component (B) | PETG [g] | 18 | 18 | 18 | 18 |
| | BATG [g] | 12 | 12 | 12 | 12 |
| component (C) | CPI-310FG [g] | 2 | 2 | 2 | 2 |
| component (D) | crystalline silica-2 [g] | 42 | 42 | 42 | 43 |
| component (E) | GW-1500 [g] | | | | |
| | BYK-P 105 [g] | | | | |
| | DISPERBYK-111 [g] | | | | |
| | ED153 [g] | 0.27 | 0.45 | 0.90 | 1.82 |
| component (B) / {component (A)+component (B)} [mass%] | | 50 | 50 | 50 | 50 |
| content of aliphatic compound in component (B) [mass%] | | 60 | 60 | 60 | 60 |
| content of filler [mass%] | | 40 | 40 | 40 | 40 |
| content of component (E) [mass%] | | 0.26 | 0.43 | 0.86 | 1.71 |
| thixotropy | | ○ | ○ | ○ | ○ |
| film thickness variation [µm] | | 0.3 | 0.3 | 0.3 | 0.3 |
| dispersibility of crystalline silica (D) | | ○ | ○ | ○ | ○ |
| 180°C elastic modulus [GPa] | | 5.5 | 5.1 | 4.6 | 4.1 |

It should be noted that the ratio of "component (B) / {component (A) + component (B)} (mass%)" in Tables means the content of the cationic polymerizable compound (B) relative to the sum, which accounts for 100 mass%, of the polyimide (A) and the cationic polymerizable compound (B). The "content of aliphatic compound in component (B) (mass%)" in Tables means the content of the aliphatic species in the cationic polymerizable compound (B) relative to the total content, which accounts for 100 mass%, of the cationic polymerizable compound (B). The "content of filler (mass%)" in Tables means the content of the crystalline silica (D) or the content of the inorganic filler (D') other than crystalline silica relative to the total solid content, which accounts for 100 mass%, in the photosensitive resin composition. The "content of component (E) (mass%)" in Tables means the content of the dispersant (E) relative to the total solid content, which accounts for 100 mass%, in the photosensitive resin composition.

The "180°C elastic modulus (GPa)" in Tables means the measured value of each cured product, whereas the "visible light transmittance (%)" and "365 nm transmittance (%)" mean the measured value of each photosensitive resin composition coat layer. The columns for "thixotropy" in Tables show evaluation results of photosensitive resin composition varnishes, whereas the columns for "film thickness variation (µm)" show evaluation results of photosensitive resin composition coat layers. The columns for "dispersity of crystalline silica (D)" show evaluation results of photosensitive resin composition films.

## Claims

1. A photosensitive resin composition comprising a polyimide (A), a cationic polymerizable compound (B), a photocationic polymerization initiator (C), and a crystalline silica (D) and having negative type photosensitivity.

2. The photosensitive resin composition according to claim 1, wherein the polyimide (A) has an alicyclic structure in the backbone chain.

3. The photosensitive resin composition according to claim 2, wherein the polyimide (A) has a structure derived from an alicyclic tetracarboxylic dianhydride.

4. The photosensitive resin composition according to claim 1, wherein the cationic polymerizable compound (B) accounts for 30 to 70 mass% relative to the total mass, which accounts for 100 mass%, of the polyimide (A) and the cationic polymerizable compound (B).

5. The photosensitive resin composition according to claim 1, wherein the content of the aliphatic species in the cationic polymerizable compound (B) is 60 mass% or more relative to the total content, which accounts for 100 mass%, of (B) the cationic polymerizable compound.

6. The photosensitive resin composition according to claim 1, wherein the crystalline silica (D) has an average particle diameter of 0.1 to 3.0 µm.

7. The photosensitive resin composition according to claim 1, wherein the crystalline silica (D) has a maximum particle diameter of 0.5 to 9.0 µm.

8. The photosensitive resin composition according to claim 1, wherein the content of the crystalline silica (D) is 30 to 80 mass% relative to the total solid content, which accounts for 100 mass%, in the photosensitive resin composition.

9. The photosensitive resin composition according to claim 1, wherein the crystalline silica (D) has a surface treated with a silane coupling having at least one selected from the group consisting epoxy group, styryl group, isocyanurate group, acid anhydride groups, carboxylic acid groups, alkyl groups having 1 to 10 carbon atoms, and phenyl group.

10. The photosensitive resin composition according to claim 1, further comprising a dispersant (E).

11. The photosensitive resin composition according to claim 10, wherein the dispersant (E) has an amine value of 0 and an acid value of 10 to 400.

12. The photosensitive resin composition according to claim 10, wherein the dispersant (E) is a phosphate ester based dispersant.

13. A photosensitive resin composition film having a photosensitive resin composition coat layer made of the photosensitive resin composition according to claim 1.

14. A photosensitive resin composition film according to claim 13, wherein the photosensitive resin composition coat layer has a visible light transmittance of 70% or more and 100% or less at a depth of 30 µm.

15. A cured product obtainable by heat-curing of the photosensitive resin composition according to claim 1 or of the photosensitive resin composition coat layer in the photosensitive resin composition film according to claim 13.

16. The cured product according to claim 15, wherein the tensile modulus thereof at 180°C is 4 GPa or more.

17. An electronic component comprising a cured product according to claim 15.

18. The electronic component according to claim 17, having a hollow structure provided with a roof member made of the cured product.

19. The electronic component according to claim 17, wherein the electronic component is a high frequency filter.
